# EUROPEAN PATENT APPLICATION

(11) **EP 4 611 040 A1**
(43) Date of publication of application: **03.09.2025**
(21) Application number: 24160647.4
(22) Date of filing: 29.02.2024
(51) Int. Cl.: H01L 27/02, H01L 29/06

(54) **SUPER JUNCTION REGION FOR LOW CAPACITANCE ESD SEMICONDUCTOR DEVICES**

(71) Applicant: Nexperia B.V., 6534 AB Nijmegen (NL)
(72) Inventor: Holland, Steffen, 22529 Hamburg (DE)
(74) Representative: Pjanovic, Ilija

(57) **Abstract**

An ESD protection device is presented comprising one or more semiconductor devices comprising one or more n-doped regions and one or more p-doped regions. The semiconductor devices are placed in a super junction region comprising one or more p-type regions and one or more n-type regions. The one or more p-type regions and the one or more n-type regions are alternatingly arranged within the super junction region. The super junction region extends from the one or more semiconductor devices in the direction of a substrate of the one or more semiconductor devices. Preferable, the super junction region forms depletion regions such that the super junction region is fully depleted at 0V, when the ESD protection device is in use.

## Description

### Technical field

The present disclosure relates to electrostatic discharge (ESD) semiconductor devices, and more specifically to low capacitance ESD protection devices.

### Background

ESD protection devices and transient voltage suppressor (TVS) protection devices may be used to safeguard electronic circuits against electrical threats. ESD protection devices protect electronic components from damage caused by electrostatic discharge events, i.e., sudden, high-voltage discharge of static electricity. ESD protection devices enable the energy associated with electrostatic discharge to be quickly diverted and dissipated to prevent damaging sensitive components. TVS protection devices provide protection against transient voltage spikes or surges, which may be caused by various factors, including lightning, power grid fluctuations, or inductive loads switching off. TVS protection devices enable the voltage to clamp to a safe level and absorb the transient energy.

ESD protection devices are typically placed at input/output ports, connectors, and other points where the circuit is susceptible to electrostatic discharge. TVS protection devices are typically positioned at points where transient voltage spikes are likely to enter the circuit, such as power supply lines, communication lines, or other vulnerable connections.

A system-level ESD protection device is a component or a set of components designed to protect an entire electronic system from electrostatic discharge events. It may be specifically engineered to provide comprehensive protection at the system-level, covering multiple points of entry and protecting various components within the system.

It may be desirable for ESD protection devices, system-level ESD protection devices and TVS protection devices to have low capacitance to avoid introducing significant capacitance into the protected circuits. A low capacitance is beneficial for maintaining signal integrity in high-speed communication systems and in highfrequency applications.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to provide an improved, low capacitance semiconductor ESD protection device, such as diode or silicon-controlled rectifiers (SCR) based ESD protection devices. Moreover, the improved ESD protection device may be used in or as a system-level ESD protection device and/or in or as a TVS protection device. At system-level, the ESD protection device may, e.g., be used for maintaining signal integrity of high-speed data lines, such as data transfers over high-speed ports of a USB-4 system or any other data bus or port.

According to an aspect of the present disclosure, an ESD protection device is presented. The ESD protection device may include one or more semiconductor devices. Such semiconductor device may include one or more n-doped regions and one or more p-doped regions to form the semiconductor device. The ESD protection device may further include a super junction region. The super junction region may include one or more p-type regions and one or more n-type regions. The one or more semiconductor devices may be arranged within the super junction region. The one or more p-type regions and the one or more n-type regions may be alternatingly arranged within the super junction region. The super junction region may extend from the one or more semiconductor devices in the direction of a substrate of the one or more semiconductor devices.

In an embodiment, the super junction region may form depletion regions such that the super junction region is fully depleted at 0V. Signals may be biased and thus the application may run at a different voltage than 0V, however, this does not affect the function of the device.

In an embodiment, the one or more semiconductor devices may be arranged at a silicon surface.

In an embodiment, the one or more p-type regions and the one or more n-type regions may be horizontally aligned, substantially in parallel with a silicon surface, within the super junction region.

In an embodiment, the one or more p-type regions and the one or more n-type regions may be vertically aligned, substantially orthogonal to a silicon surface, within the super junction region.

In an embodiment, the super junction region may include one or more additional doping regions.

In an embodiment, the super junction region may be arranged on top of a lowly doped substrate.

In an embodiment, the ESD protection device may include a plurality of super junction regions each comprising a portion of the one or more semiconductor devices of the ESD protection device.

In an embodiment, the super junction regions may be separated by a lowly doped or a highly doped epitaxial region.

In an embodiment, two super junction regions may be separated by a barrier. The barrier may include a trench extending into a substrate to a depth deeper than the two super junction regions. The trench may be filled with an isolating material, a conducting material or a doped poly silicon. Alternatively, a barrier may be created by a deep diffusion which is deeper than the super junction region.

In an embodiment, the super junction region has a depth in a range of 5µm to 40µm, preferably about 20µm.

In an embodiment, the one or more semiconductor devices include a diode and/or an SCR and/or a bipolar junction transistor (BJT).

According to an aspect of the present disclosure, a system-level ESD protection device is presented, which includes an ESD protection device having one or more of the above-described features.

According to an aspect of the present disclosure, a TVS protection device is presented, which includes an ESD protection device having one or more of the above-described features.

### Brief description of the Drawings

Embodiments of the present disclosure will now be described, by way of example only, with reference to the accompanying schematic drawings in which corresponding reference symbol indicate corresponding parts, in which:
Fig. 1 is a cross-sectional side view of a prior art diode device;
Fig. 2 is a cross-sectional side view of a diode device in a super junction region;
Figs. 3A-3B are graphs comparing capacitance characteristics of the diode devices of Fig. 1 and Fig. 2;
Fig. 4A is a cross-sectional side view of a diode device and Fig. 4B is a graph showing doping, electron and hole concentrations of the diode device of Fig. 4A;
Figs. 5A, 6A, 7A, 8A and 9A show various examples of ESD protection devices without a barrier in between horizontally aligned super junction regions;
Figs. 5B, 6B, 7B, 8B and 9B show various examples of ESD protection devices with a barrier in between horizontally aligned super junction regions to avoid punch throughs;
Fig. 10 shows an example of an ESD protection device including a well for avoiding punch through;
Figs. 11-16 show various examples of ESD protection devices in vertically aligned super junction regions; and
Fig. 17 show an example of an ESD protection device with a barrier in between vertically aligned super junction regions to avoid punch throughs.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The present disclosure presents a super junction region for realizing low capacitance ESD protection devices and enables lowering junction capacitances by creating a fully depleted super junction region at 0V. The super junction region of the present disclosure includes alternating layers of lowly doped n- and p-type material. The regions of alternative doping regions of opposite polarity are arranged next to another, either horizontally aligned (i.e., substantially in parallel with the silicon surface) or vertically aligned (i.e., substantially orthogonal to the silicon surface). The doping concentration and the thickness of the doping regions are chosen in a way that the depletion regions substantially or fully overlap and the whole super junction region is depleted at 0V.

Signals may be biased and thus the application may run at a different voltage than 0V, however, this does not affect the function of the device.

A super junction region in a parallel configuration may include relatively thin layers with p-type and n-type doping, which are located vertically on top of each other, thereby forming a super junction epitaxial (epi) region. The doping and the thickness of the layers may be designed such that the depletion regions deplete each layer completely. There are different ways to produce such a stack of thin layers of opposite polarities, which are further described below.

A super junction region in an orthogonal configuration may include vertical regions of opposite doping concentrations. Such super junction region in orthogonal configuration may, e.g., be realized by etching trenches and filling them with doped polysilicon. The doping inside the trench may be adjusted to become fully depleted at 0V as well as the remaining substrate regions between the trenches. The trench depth may determine the extension of the depletion region.

It has been found that when an ESD protection device is added into a fully depleted region (i.e., fully depleted at 0V), the junction capacitance may advantageously be reduced. The junction capacitance may be significantly reduced, e.g., by about 25% to 40% or even higher, when implementing a super junction region in accordance with the present disclosure.

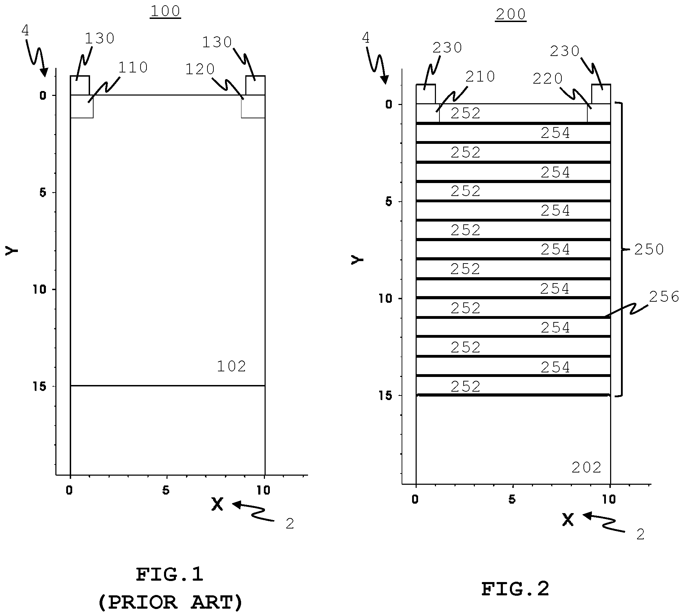

Fig. 1 shows a cross-sectional side view of an example conventional semiconductor diode device 100 in a lowly doped EPI region 102, as known from the prior art. The diode device of Fig. 1 includes an n-region 110, a p-region 120 and a contact or connection region 130. The n-region 110 and its corresponding connection region 130 may form the cathode of the diode and the p-region 120 and its corresponding connection region 130 may form the anode of the diode. The x-axis 2 represents a width of the diode device 100, in this example from 0µm to 10µm. The y-axis 4 represents a depth of the diode device 100, in this example from 0µm to 20µm.

Fig. 2 shows a cross-sectional side view of an example embodiment of a semiconductor diode device 200 arranged in a super junction region 250, wherein the super junction region 250 is in a parallel configuration. Simillar to Fig. 1, the diode device 200 of Fig. 2 includes an n-region 210, a p-region 220 and a contact or connection region 230. The n-region 210 and its corresponding connection region 230 may form the cathode of the diode and the p-region 220 and its corresponding connection region 230 may form the anode of the diode. The x-axis 2 represents a width of the diode device 200, in this example from 0µm to 10µm. The y-axis 4 represents a depth of the diode device 200, in this example from 0µm to 20µm. The super junction epi region 250 extends into the semiconductor device towards a lowly doped epi 202, in this example from 0µm to 15µm. The depth of the super junction epi region 250 may be different depending on design constrains. The super junction epi region 250 may fully replace the lowly doped epi 202, in which case the super junction epi region 250 would extend, in the example of Fig. 2, to a depth of 20µm.

The super junction region 250 includes one or more p-type regions 252 and one or more n-type regions 254, which are alternatingly arranged in vertical direction (y-axis 4). Optionally, additional regions 256 with a doping different from the doping of the p-type regions 252 and the n-type regions 254 may be arranged in between the p-type regions 252 and the n-type regions 254. The thickness of the additional doping regions 256, if present, is typically much smaller than the thickness of the p-type regions 252 and the p-type regions 254. All p-type regions 252 may have a substantially same doping concentration and all n-type regions 254 may have a substantially same doping concentration.

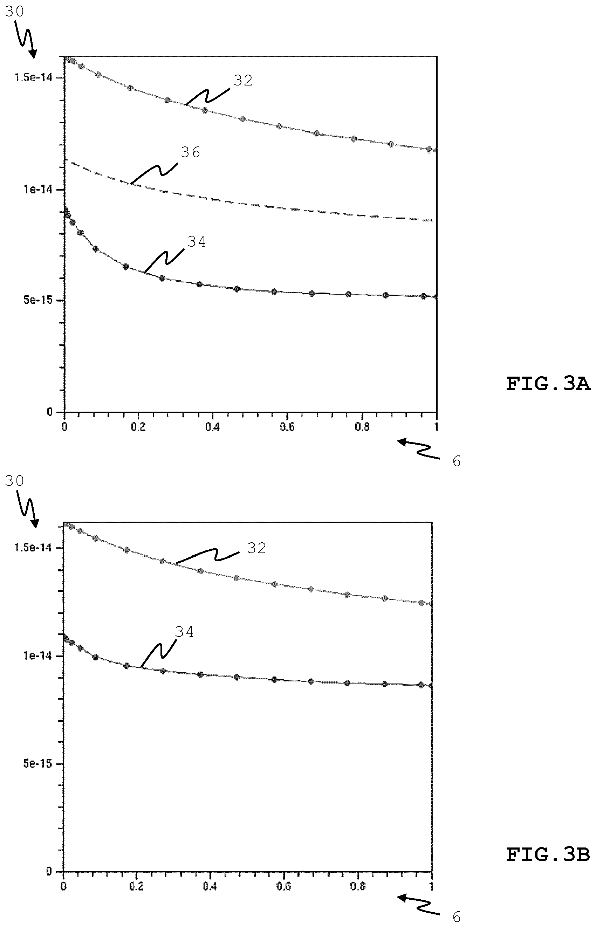

An analysis of the capacitance of the diode devices 100 and 200 at different voltage levels is show in Fig. 3A and Fig. 3B. In Fig. 3A, the distance between the anode and the cathode of the diode 100, 200 is about 8µm; in Fig. 3B, the distance between the anode and the cathode of the diode 100, 200 is about 3µm. The voltage level is shown along the x-axis 6, in this example being in a range of 0V to 1V. The capacitance is shown along the y-axis 30, in this example being in a range of 0F to 1.6e⁻¹⁴F. Line 32 represents the capacitance of the conventional diode 100 in the lowly doped epi 102. Line 34 represents the capacitance of the diode 200 in the super junction region 250.

Comparing lines 32 and 34 gives an indication of the improvement in capacitance of an ESD protection device in accordance with the present disclosure. In this example, when the anode and cathode are about 8µm apart (Fig. 3A), the reduction in junction capacitance as a result of the super junction region 250 is about 40% at 0V. If the doping of one layer is about 50% higher (i.e., a sub-optimal configuration), the capacitance of the diode 200 is still 30% to 40% lower compared to the reference diode device 100, which is depicted by the line 36. When the anode and cathode are about 3µm apart (Fig. 3B), the reduction in junction capacitance as a result of the super junction region 250 is about 30% at 0V. Thus, a significant reduction in capacitance is achieved by the super junction region of the present disclosure.

The parallel configuration of a super junction epitaxial layer, such the super junction region 250 of Fig. 2, may be created in various manners.

In a first example, an epi may be grown where the doping is changed for each layer, thereby forming the p-type regions 252 and n-type regions 254. The doping of these layers does not need to be extremely low but it should be rather low, typically in a range of 1e12cm⁻³ to 1e18cm⁻³, preferably in a range of 1e14cm⁻³ to 1e15cm⁻³. Advantageously, the epi doping of the lowly doped epi substrate 202 may be in a usual range, e.g., similar to the concentration of the epi substrate 102 of Fig. 1, such as a having concentration of about 1e14cm⁻³, which may be processed using existing manufacturing tools. The doping concentration and thickness of each same type layer (i.e., of the p-type regions 252 and of the n-type regions 254) are preferably substantially the same to achieve an optimal performance. However, as can be seen in Fig. 3A (line 36), even if there is a mismatch in doping concentration and/or thickness between the layers, a significantly lower capacitance may be achieved.

In a second example, a super junction region 250 may be created by growing a thick p-type epi on a substrate (i.e., having a thickness large enough to encompass the desired super junction region) or even just use a substrate with a low doping concentration, such as lowly doped epi 102, and then performing a multi-energy hydrogen blanket implant with defined dose to create the alternating p-type regions 252 and n-type regions 254. With the right temperature step at around 400°C, the hydrogen creates an n-type doping. By choosing the right dose and energies of the hydrogen implants, a super junction epi may be produced in a cost-effective manner by implanting as a blanket implant. With hydrogen, implantation depths of 20µm can be reached with conventional high energy implanters (e.g., in the range of 1Mev to 2MeV) and thus very thick superjunction epitaxial regions can be created, such as the 15µm thick super junction region 250 or having any other depth up to the implantation depth limit.

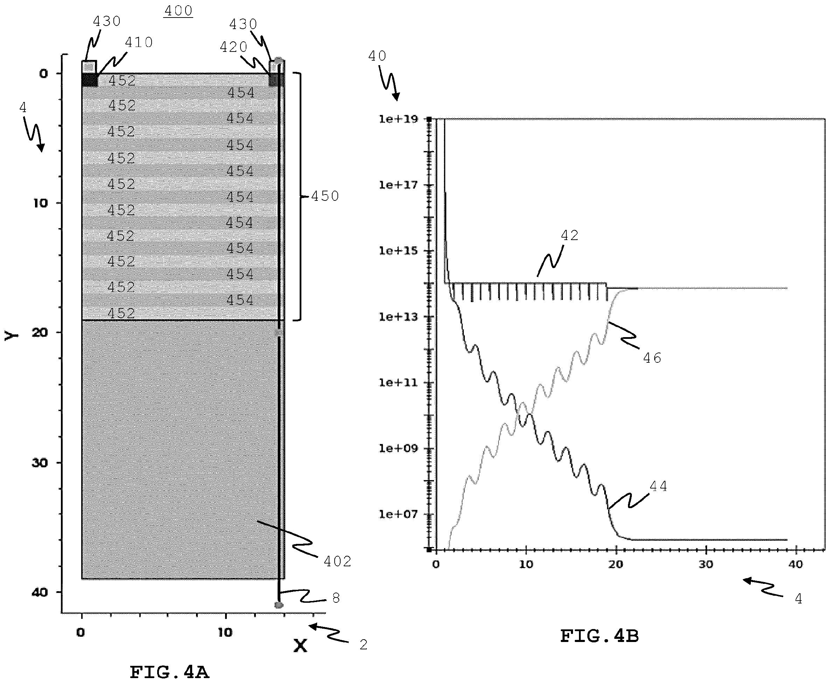

Fig. 4A and Fig. 4B show the results of a simulation of a doping, electron and hole concentration of an ESD protection device, in this example a simple lateral diode 400, arranged in a super junction region 450.

Fig. 4A shows a cross-sectional side view of an example embodiment of the diode 400 and the super junction region 450 in a parallel configuration. Simillar to Fig. 2, the diode 400 of Fig. 4A includes an n-region 410, a p-region 420 and a contact or connection region 430. The n-region 410 and its corresponding connection region 430 may form the cathode of the diode and the p-region 420 and its corresponding connection region 430 may form the anode of the diode. The super junction region 450 includes one or more p-type regions 452 and one or more n-type regions 454, which are alternatingly arranged in vertical direction (y-axis 4). The x-axis 2 represents a width of the diode 400, in this example from 0µm to 12µm. The y-axis 4 represents a depth of the diode device 400, in this example from 0µm to about 40µm. The super junction epi region 450 extends into the semiconductor device towards a lowly doped substrate 402, in this example from 0µm to about 20µm.

Along the line 8, which is drawn in Fig. 4A below the anode contact from a depth of 0µm to about 40µm, the doping, electron and hole concentration have been simulated, the results of which are shown in Fig. 4B. In Fig. 4B, the x-axis 4 represents the depth of the diode device 400 along the line 8, in this example from 0µm to about 40µm, and the y-axis 40 represents the concentration, in this example from 1e6cm⁻³ to 1e19cm⁻³. Line 42 represents the doping concentration, line 44 represent the electron concentration and line 46 represents the hole concentration. From Fig. 4B it follows that the whole super junction region 450 is depleted at 0V (or in other words: the whole super junction epitaxial layer is depleted at 0V), as can be seen by the lower electron concentration 44 and hole concentration 46 compared to the doping concentration 42. Moreover, the charge concentration shows an oscillating behavior, which demonstrates that the depletion region in principle can be extended indefinitely into the substrate if enough layers 452, 454 are added.

Preferably, the whole epitaxial region is completely depleted at 0V and thus care must be taken to avoid a punch through between regions which should stay isolated. Otherwise, a (potentially high) leakage current may occur.

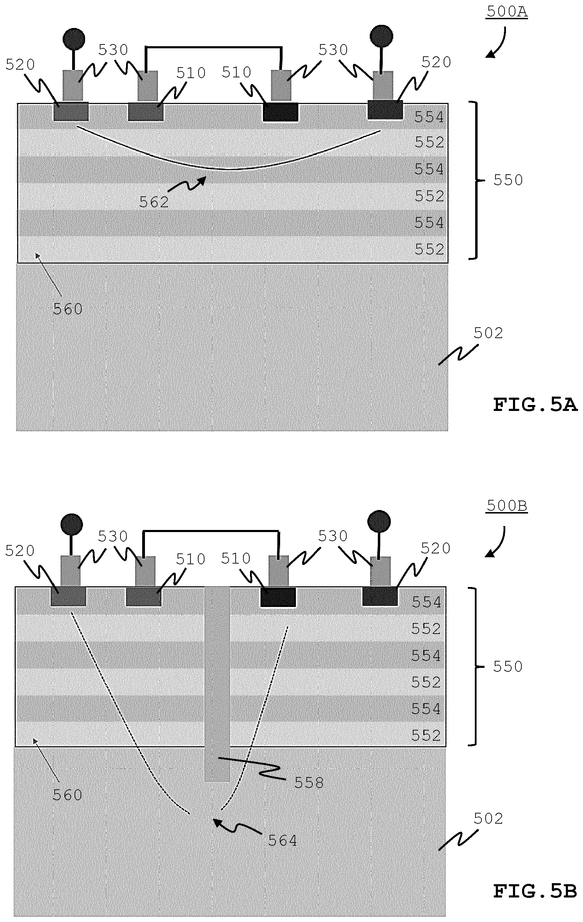

An example of a diode configuration 500A, 500B having a potential leakage current and a solution to avoid such leakage current are shown in Fig. 5A and Fig. 5B. In Fig. 5A the diode configuration 500A is shown, including n-doped regions 510, p-doped regions 520 and connection regions 530 of the diode devices and further including a super junction region 550. The super junction region 550 includes an alternating stack of p-type regions 552 and n-type regions 554. In this example, the super junction region 550 is arranged on top of a lowly doped epi or substrate 502. The super junction region 550 forms depletion regions 560, preferably in all p-type regions 552 and all n-type regions 554. The line 562 depicts a potential punch through between the p-doped regions 520 of the diode devices.

The diode configuration 500B is similar to the diode configuration 500A, with the addition of a barrier 558, resulting in the punch through being avoided, as depicted by the interrupted line 564. The barrier 558 may be created, e.g., as a deep trench or a deep diffusion, which extends deep into the substrate 502 so that the depletion regions 560 are no longer touching the same polarity regions (in this example the n-doped regions 510 or the p-doped regions 520) at the different diodes. Each trench may surround a region which needs to be isolated. The trenches may be filled with isolating or conducting material to form the barrier 558. Stacks of antiparallel or anti-serial diodes typically need to be isolated from each other with deep trenches (isolating or conducting material) or deep isolation diffusions, e.g., extending from the top of the super junction region 550 up to the depth of the super junction region 550 or beyond the depth of the super junction region 550 into the lowly doped epi or substrate 502, such as shown in Fig. 5B.

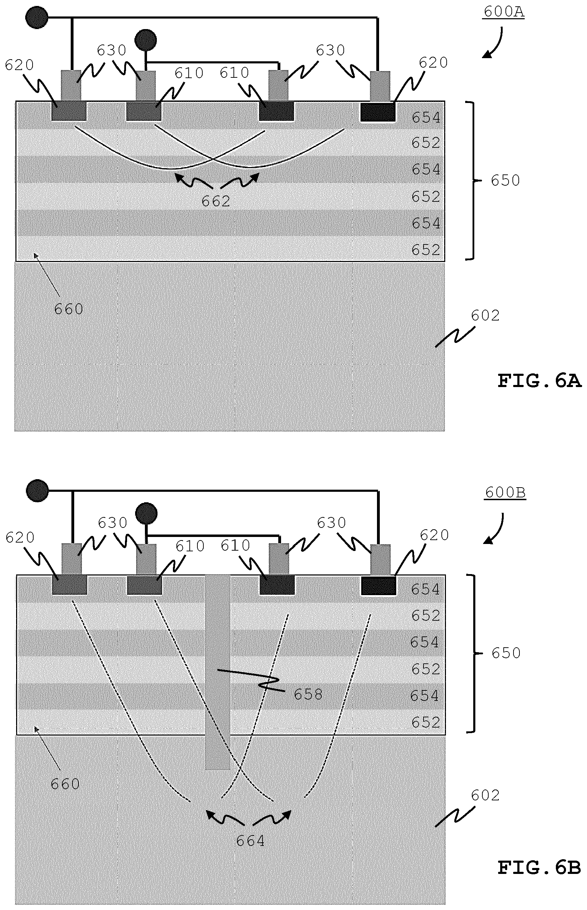

Fig. 6A and Fig. 6B show an alternative diode configuration 600A, 600B having two potential leakage currents and a solution to avoid such leakage currents. In Fig. 6A the diode configuration 600A is shown, including n-doped regions 610, p-doped regions 620 and connection regions 630 of the diode devices and further including a super junction region 650. The super junction region 650 includes an alternating stack of p-type regions 652 and n-type regions 654. In this example, the super junction region 650 is arranged on top of a lowly doped epi or substrate 602. The super junction region 650 forms depletion regions 660, preferably in all p-type regions 652 and all n-type regions 654. The lines 662 depict potential punch throughs between the n-doped regions 510 and between the p-doped regions 520 of the diode devices.

The diode configuration 600B is similar to the diode configuration 600A, with the addition of a barrier 658, resulting in the punch throughs being avoided, as depicted by the interrupted lines 664. The barrier 658 may similarly be created as the barrier 558 of Fig. 5.

In the above examples, the ESD protection device is implemented as a diode device, such as diode device 200, 400, 500A, 500B, 600A, 600B, placed inside a super junction region, such as super junction region 250, 450, 550, 650. The present application is not limited to diode devices and may be applied to different types of ESD protection devices. A non-limiting other example of an ESD protection device that may be advantageously placed in a super junction region according to the present disclosure is an SCR based ESD protection device.

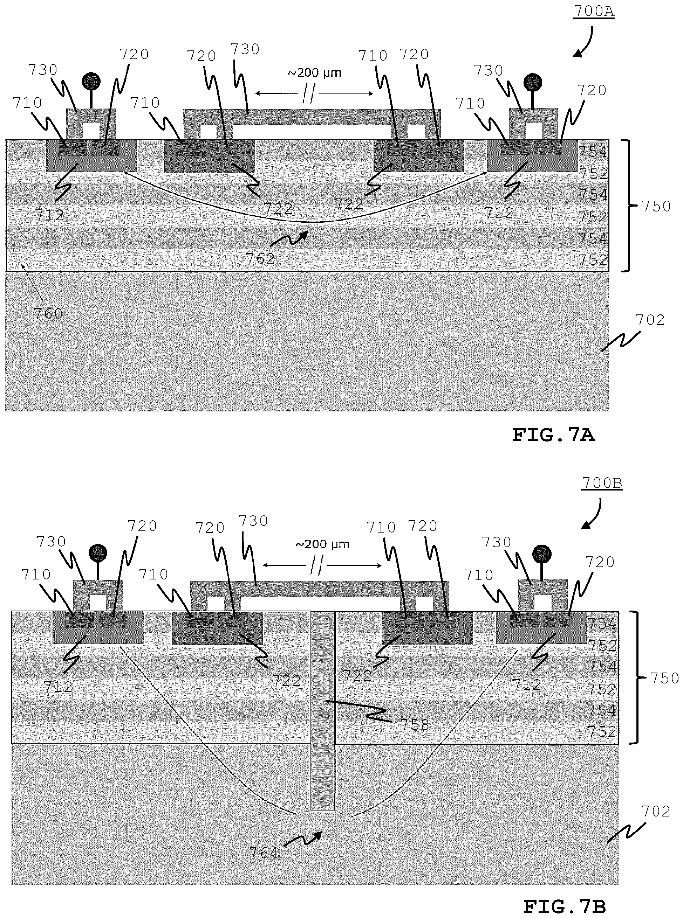

In the example of Fig. 7A, an SCR configuration 700A is shown, including a unidirectional SCR with an SCR in one direction and a forward diode in the other direction. The SCR configuration 700A includes n-doped regions 710, p-doped regions 720, n-wells 712, p-wells 722 and connection regions 730. The SCRs are arranged in a super junction region 750, which includes an alternating stack of p-type regions 752 and n-type regions 754. In this example, the super junction region 750 is arranged on top of a lowly doped epi or substrate 702. The super junction region 750 forms depletion regions 760, preferably in all p-type regions 752 and all n-type regions 754.

As in the example of Fig. 5A and Fig. 6A, a potential leakage current may occur in the SCR configuration 700A. The line 762 depicts a potential punch through between the SCR devices. Such punch through may occur even though the SCRs are over 200µm away because both input pins are connected to a n-type doping 710.

Fig. 7B shows a solution to avoid such leakage current. The SCR configuration 700B is similar to the SCR configuration 700A, with the addition of a barrier 758, resulting in the punch through being avoided, as depicted by the interrupted line 764. The barrier 658 may be similarly created as the barrier 558 of Fig. 5.

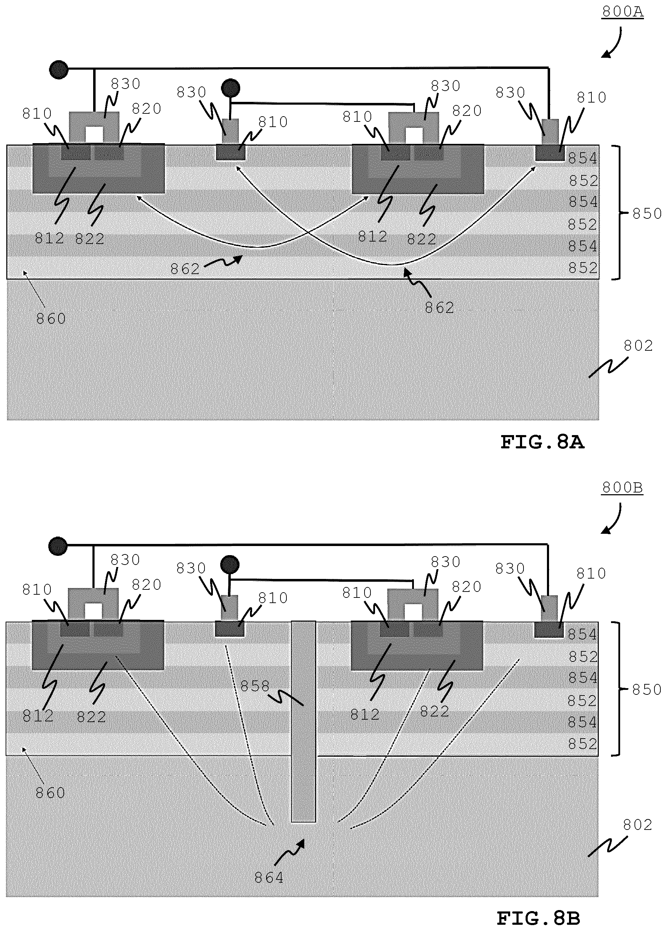

Fig. 8A and Fig. 8B show an alternative SCR configuration 800A, 800B having two potential leakage currents and a solution to avoid such leakage currents. In the example of Fig. 8A, an SCR configuration 700A is shown, including a unidirectional SCR with an SCR in one direction and two reverse diodes in the other direction. The SCR configuration 800A includes n-doped regions 810, p-doped regions 820, n-wells 812, p-wells 822 and connection regions 830. The SCRs are arranged in a super junction region 850, which includes an alternating stack of p-type regions 852 and n-type regions 854. In this example, the super junction region 850 is arranged on top of a lowly doped epi or substrate 802. The super junction region 850 forms depletion regions 860, preferably in all p-type regions 852 and all n-type regions 854.

As in the example of Fig. 7A, a potential leakage current may occur in the SCR configuration 800A. The lines 862 depict potential punch throughs between the SCR devices. Fig. 8B shows a solution to avoid such leakage current. The SCR configuration 800B is similar to the SCR configuration 800A, with the addition of a barrier 858, resulting in the punch throughs being avoided, as depicted by the interrupted lines 864. The barrier 858 may be similarly created as the barrier 558 of Fig. 5.

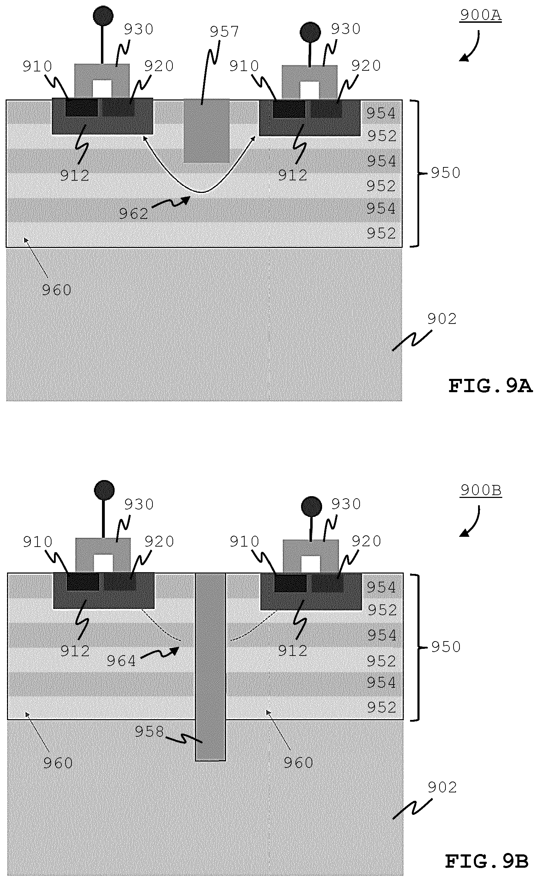

Other concepts, such as a bidirectional SCR 900A, 900B as shown in Fig. 9A and Fig. 9B may be realized with a doped poly filled trench 958 as a barrier. In the example of Fig. 9B, a barrier based on another isolation may impede the current flow inside the device and change the device behavior and is therefore less preferred. In Fig. 9A and Fig. 9B, the SCR configuration 900A, 900B includes n-doped regions 910, p-doped regions 920, n-wells 912 and connection regions 930. The SCRs are arranged in a super junction region 950, which includes an alternating stack of p-type regions 952 and n-type regions 954. In this example, the super junction region 950 is arranged on top of a lowly doped epi or substrate 902. The super junction region 950 forms depletion regions 960, preferably in all p-type regions 952 and all n-type regions 954.

Although a small barrier 957 may be present in the bidirectional SCR 900A, a potential leakage current may occur. The line 962 depict a potential punch through between the SCR devices. Fig. 9B shows a solution to avoid such leakage current. The SCR configuration 900B is similar to the SCR configuration 900A, with the addition of a deep barrier 958, resulting in the punch throughs being avoided, as depicted by the interrupted line 964. The barrier 958 may be similarly created as the barrier 558 of Fig. 5, but then preferably being doped poly filled.

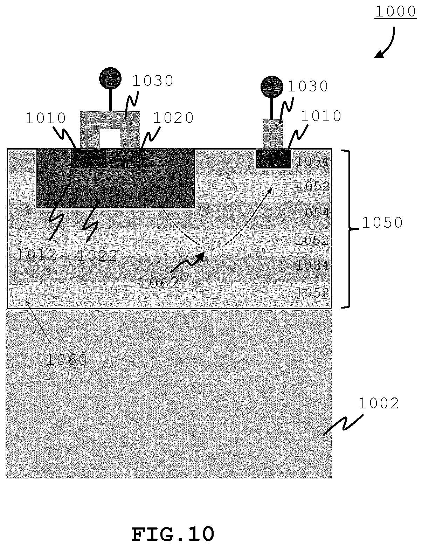

Fig. 10 shows an alternative solution for preventing potential punch throughs between devices placed in a super junction region of an ESD protection device 1000. In Fig. 10, the two devices include n-doped regions 1010, p-doped regions 1020 and connection regions 1030. The devices are arranged in a super junction region 1050, which includes an alternating stack of p-type regions 1052 and n-type regions 1054. In this example, the super junction region 1050 is arranged on top of a lowly doped epi or substrate 1002. The super junction region 1050 forms depletion regions 1060, preferably in all p-type regions 1052 and all n-type regions 1054. Punch through may be avoided by placing wells of opposite polarities, in this example an n-well 1012 and a p-well 1022, in a way that these wells avoid the punch through. The interrupted line 1062 depicts that no punch through is present as a result of the wells 1012, 1022 of opposite polarities.

A super junction region in an orthogonal configuration may be created by etching trenches in a lowly doped epitaxial region or substrate. The trenches may be filled with lowly doped polysilicon and the width of the trench and the doping concentration may be chosen such that they match to the doping concentration of the monocrystalline silicon and the spacing between the trenches. Compared to a parallel (i.e., horizontal) configuration, such as shown in Figs. 2-10, an orthogonal (i.e., vertical) configuration has the advantage that electrical isolation may be created by creating islands of super junction regions and by processing the trenches only in selected regions. As a result, barriers, such as barriers 558, 658, 758, 858, 958, are not needed in an orthogonal configuration.

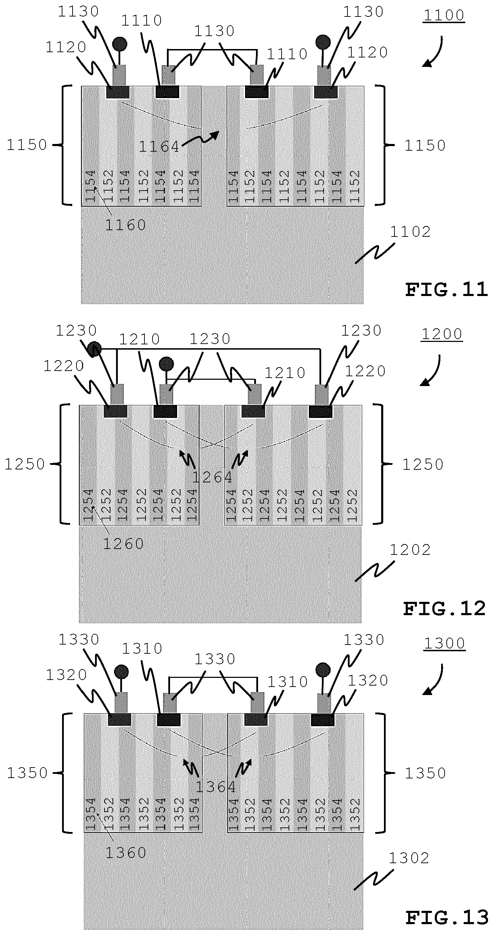

Figs. 11-16 show various non-limiting example embodiments of ESD protection devices arranged in orthogonally oriented super junction regions.

Fig. 11 shows an example of a diode configuration 1100, similar to the diode configuration 500A, 500B but arranged in orthogonally oriented super junction regions 1150. The diode configuration 1100 includes n-doped regions 1110, p-doped regions 1120 and connection regions 1130 of the diode devices and further includes super junction regions 1150. Each of the super junction regions 1150 includes alternating trenches of p-type regions 1152 and n-type regions 1154. The super junction regions 1150 form depletion regions 1160, preferably in all p-type regions 1152 and all n-type regions 1154. In this example, the super junction regions 1150 are arranged on top of a lowly doped epi or substrate 1102. The super junction regions 1150 are separated, in this example by said lowly doped epi material 1102, but it may be a highly doped region. The line 1164 depicts that there is no punch through between the diode devices.

Fig. 12 shows an example of an alternative diode configuration 1200, similar to the alternative diode configuration 600A, 600B but arranged in orthogonally oriented super junction regions 1250. The diode configuration 1200 includes n-doped regions 1210, p-doped regions 1220 and connection regions 1230 of the diode devices and further includes super junction regions 1250. Each of the super junction regions 1250 includes alternating trenches of p-type regions 1252 and n-type regions 1254. The super junction regions 1250 form depletion regions 1260, preferably in all p-type regions 1252 and all n-type regions 1254. In this example, the super junction regions 1250 are arranged on top of a lowly doped epi or substrate 1202. The super junction regions 1250 are separated, in this example by said lowly doped epi material 1202, but it may be a highly doped material. The lines 1264 depict that there is no punch through between the diode devices.

Fig. 13 shows an example of another alternative diode configuration 1300, similar to the diode configuration 1100 but with n-doped and p-doped regions of the diodes being inverted. I.e., the diode configuration 1300 includes n-doped regions 1310, p-doped regions 1320 and connection regions 1330 of the diode devices and further includes super junction regions 1350. Each of the super junction regions 1350 includes alternating trenches of p-type regions 1352 and n-type regions 1354. The super junction regions 1350 form depletion regions 1360, preferably in all p-type regions 1352 and all n-type regions 1354. In this example, the super junction regions 1350 are arranged on top of a lowly doped epi or substrate 1302. The super junction regions 1350 are separated, in this example by said lowly doped epi material 1302, but it may be a highly doped material. The lines 1364 depict that there is no punch through between the diode devices.

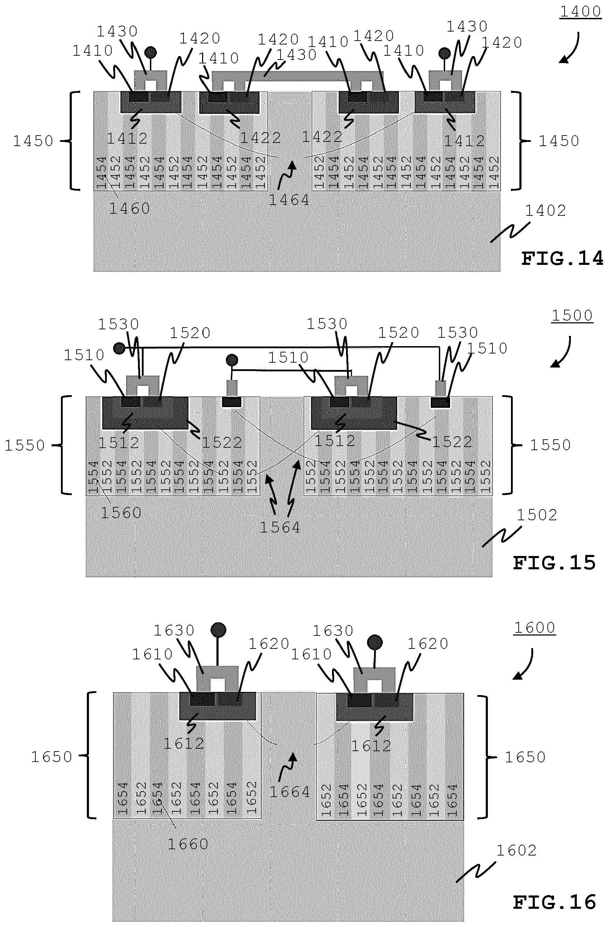

Fig. 14 shows an example of an SCR based configuration 1400, similar to the SCR based configuration 700A, 700B but arranged in orthogonally oriented super junction regions 1450. The SCR configuration 1400 includes n-doped regions 1410, p-doped regions 1420, n-wells 1412, p-wells 1422 and connection regions 1430 of the SCR devices and further includes super junction regions 1450. Each of the super junction regions 1450 includes alternating trenches of p-type regions 1452 and n-type regions 1454. The super junction regions 1450 form depletion regions 1460, preferably in all p-type regions 1452 and all n-type regions 1454. In this example, the super junction regions 1450 are arranged on top of a lowly doped epi or substrate 1402. The super junction regions 1450 are separated, in this example by said lowly doped epi material 1402, but it may be a highly doped material. The line 1464 depicts that there is no punch through between the SCR devices.

Fig. 15 shows an example of an alternative SCR based configuration 1500, similar to the alternative SCR based configuration 800A, 800B but arranged in orthogonally oriented super junction regions 1550. The alternative SCR configuration 1500 includes n-doped regions 1510, p-doped regions 1520, n-wells 1512, p-wells 1522 and connection regions 1530 of the SCR devices and further includes super junction regions 1550. Each of the super junction regions 1550 includes alternating trenches of p-type regions 1552 and n-type regions 1554. The super junction regions 1550 form depletion regions 1560, preferably in all p-type regions 1552 and all n-type regions 1554. In this example, the super junction regions 1550 are arranged on top of a lowly doped epi or substrate 1502. The super junction regions 1550 are separated, in this example by said lowly doped epi material 1502, but it may be a highly doped material. The lines 1564 depict that there is no punch through between the SCR devices.

Fig. 16 shows an example of a bidirectional SCR configuration 1600, similar to the bidirectional SCR configuration 900A, 900B but arranged in orthogonally oriented super junction regions 1650. The bidirectional SCR configuration 1600 includes n-doped regions 1610, p-doped regions 1620, n-wells 1612 and connection regions 1630 of the SCR devices and further includes super junction regions 1650. Each of the super junction regions 1650 includes alternating trenches of p-type regions 1652 and n-type regions 1654. The super junction regions 1650 form depletion regions 1660, preferably in all p-type regions 1652 and all n-type regions 1654. In this example, the super junction regions 1650 are arranged on top of a lowly doped epi or substrate 1602. The super junction regions 1650 are separated, in this example by said lowly doped epi material 1602, but it may be a highly doped material. The line 1664 depict that there is no punch through between the SCR devices.

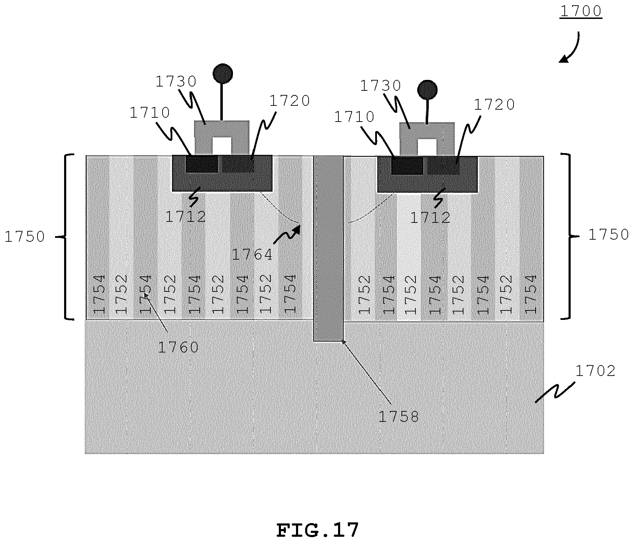

In the examples of Figs. 11-16 the orthogonally oriented super junction regions 1150, 1250, 1350, 1450, 1550, 1650 are separated by the lowly doped epi 1102, 1202, 1302, 1402, 1502, 1602. Alternatively, the orthogonally oriented super junction regions may be separated by another material, such as a doped poly silicon. An example hereof is shown in Fig. 17, which shows a bidirectional SCR configuration 1700, similar to the bidirectional SCR configuration 1600, but with two orthogonally oriented super junction regions 1750 being separated by a barrier 1758, such as a doped poly silicon trench. Fig. 17 further shows n-doped regions 1710, p-doped regions 1720, n-wells 1712 and connection regions 1730 of the SCR devices. Each of the super junction regions 1750 includes alternating trenches of p-type regions 1752 and n-type regions 1754. The super junction regions 1750 form depletion regions 1760, preferably in all p-type regions 1752 and all n-type regions 1754. In this example, the super junction regions 1750 are arranged on top of a lowly doped epi or substrate 1702. The line 1764 depict that there is no punch through between the SCR devices.

When including a barrier, such as barrier 1758, the devices and the orthogonally oriented super junction regions, such as the SCRs of Fig. 17 and the super junction regions 1750, may be positioned closer to each other compared to a configuration without such barrier where the super junction regions are separated by the lowly doped epi, such as shown in Figs. 11-16.

In the above examples, the alternating order of the n-type regions and p-type regions of a super junction region may be reversed. Moreover, the number of n-type regions and p-type regions of a super junction region may be different from the shown examples. The depth of the super junction region (i.e., in the y-direction 4) is typically in a range of 5µm to 40µm, e.g., about 20µm, but may be larger or smaller depending on the configuration of the ESD protection device. The number of n-type regions and p-type regions of a super junction region may be determined by a design goal of having a fully depleted super junction region at 0V. The doping and the thickness of the n-type regions and the p-type regions of a super junction region may be designed such that the depletion regions deplete each n-type region and each p-type region completely. In any of the above examples, additional layers of n-type doping and/or p-type doping may be part of the super junction region, such as shown in the example of Fig. 2 where an additional layer 256 is arranged in between the p-type regions 252 and n-type regions 254. Preferably, the n-type regions and p-type regions of a super junction region have a similar thickness (i.e., in the y-direction 4) to achieve a fully depleted super junction region at 0V, but different thicknesses are possible, especially when additional layers, such as additional layers 256, are present. The n-type regions and the p-type regions of a super junction region may be referred to as n-type layers and p-type layers of the super junction region.

The ESD protection device arranged in a super junction region according to the present disclosure may be used in any electronic device requiring ESD protection and is particularly advantageous where low capacitance of the ESD protection device is desired. In an example embodiment, the ESD protection device arranged in a super junction region according to the present disclosure may be used for or as part of a TVS protection device. In another example embodiment, the ESD protection device arranged in a super junction region according to the present disclosure may be a part of a system-level ESD protection device.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. An electrostatic discharge, ESD, protection device (200, 400, 500A, 500B, 600A, 600B, 700A, 700B, 800A, 800B, 900A, 900B, 1000, 1100, 1200, 1300, 1400, 1500, 1600, 1700) comprising:
one or more semiconductor devices comprising one or more n-doped regions (210, 410, 510, 610, 710, 810, 910, 1010, 1110, 1210, 1310, 1410, 1510, 1610, 1710) and one or more p-doped regions (220, 420, 520, 620, 720, 820, 920, 1020, 1120, 1220, 1320, 1420, 1520, 1620, 1720);
a super junction region (250, 450, 550, 650, 750, 850, 950, 1050, 1150, 1250, 1350, 1450, 1550, 1650, 1750) comprising one or more p-type regions (252, 452, 552, 652, 752, 852, 952, 1052, 1152, 1252, 1352, 1452, 1552, 1652, 1752) and one or more n-type regions (254, 454, 554, 654, 754, 854, 954, 1054, 1154, 1254, 1354, 1454, 1554, 1654, 1754),
wherein the one or more semiconductor devices are arranged within the super junction region,
wherein the one or more p-type regions and the one or more n-type regions are alternatingly arranged within the super junction region,
and wherein the super junction region extends from the one or more semiconductor devices in the direction of a substrate of the one or more semiconductor devices.

2. The ESD protection device according to claim 1,
wherein the super junction region forms depletion regions (560, 660, 760, 860, 960, 1060, 1160, 1260, 1360, 1460, 1560, 1660, 1760) such that the super junction region is fully depleted at 0V.

3. The ESD protection device according to any one of the preceding claims,
wherein the one or more semiconductor devices are arranged at a silicon surface.

4. The ESD protection device according to any one of the claims 1-3,
wherein the one or more p-type regions and the one or more n-type regions are horizontally aligned, substantially in parallel with a silicon surface, within the super junction region (250, 450, 550, 650, 750, 850, 950, 1050).

5. The ESD protection device according to any one of the claims 1-3,
wherein the one or more p-type regions and the one or more n-type regions are vertically aligned, substantially orthogonal to a silicon surface, within the super junction region (1150, 1250, 1350, 1450, 1550, 1650, 1750).

6. The ESD protection device according to any one of the preceding claims,
wherein the super junction region comprising one or more additional doping regions (256).

7. The ESD protection device according to any one of the preceding claims,
wherein the super junction region is arranged on top of a lowly doped substrate (202, 402, 502, 602, 702, 802, 902, 1002, 1102, 1202, 1302, 1402, 1502, 1602, 1702).

8. The ESD protection device according to any one of the preceding claims, comprising a plurality of super junction regions each comprising a portion of the one or more semiconductor devices of the ESD protection device.

9. The ESD protection device according to claim 8,
wherein the super junction regions are separated by a lowly doped or a highly doped epitaxial, epi, region (1102, 1202, 1302, 1402, 1502, 1602).

10. The ESD protection device according to claim 8,
wherein two super junction regions are separated by a barrier (558, 658, 758, 858, 958, 1758),
wherein the barrier comprises a trench or a deep diffusion extending into a substrate (502, 602, 702, 802, 902, 1702) to a depth deeper than the two super junction regions,
and wherein the trench is filled with one of: an isolating material; a conducting material; a doped poly silicon.

11. The ESD protection device according to any one of the preceding claims,
wherein the one or more semiconductor devices comprises one or more of: a diode; a silicon-controlled rectifier, SCR; a bipolar junction transistor, BJT.

12. A system-level electrostatic discharge, ESD, protection device comprising an ESD protection device according to any one of the claims 1-11.

13. A transient voltage suppressor, TVS, protection device comprising an ESD protection device according to any one of the claims 1-11.
